# EUROPEAN PATENT SPECIFICATION

(11) **EP 2 728 728 B1**
(45) Date of publication and mention of the grant of the patent: **01.08.2018**
(21) Application number: 13739926.7
(22) Date of filing: 11.04.2013
(51) Int. Cl.: H02M 3/22, G01R 19/00, H02M 3/337, G01R 15/18, H02M 1/00

(54) **HIGH-FREQUENCY SWITCH POWER SUPPLY AND METHOD FOR DETECTING HIGH-FREQUENCY CURRENT**
HOCHFREQUENZS-SCHALTNETZTEIL UND VERFAHREN ZUM NACHWEIS VON HOCHFREQUENZSTROM
ALIMENTATION ÉLECTRIQUE À COMMUTATEUR À HAUTE FRÉQUENCE ET PROCÉDÉ POUR DÉTECTER UN COURANT À HAUTE FRÉQUENCE

(30) Priority: 29.08.2012 CN 201210311640
(43) Date of publication of application: 07.05.2014
(73) Proprietor: Huawei Technologies Co., Ltd., Longgang District Shenzhen, Guangdong 518129 (CN)
(72) Inventor: LIU, Xujun, Shenzhen, Guangdong 518129 (CN)
(74) Representative: Gill Jennings & Every LLP
(86) International application number: PCT/CN2013/074073
(87) International publication number: WO 2014/032430

(56) References cited:
- EP-A1- 0 622 635
- CN-A- 1 805 259
- CN-A- 101 373 925
- CN-A- 101 807 857
- CN-A- 102 904 457
- US-A1- 2006 132 062
- US-B1- 7 282 871

## Description

### TECHNICAL FIELD

The present invention relates to high-frequency power conversion technologies, and in particular, to a high-frequency switch mode power supply and a method for detecting a high-frequency current.

### BACKGROUND

In power conversion, a current output by a power input circuit needs to be detected. In a prior art, a primary winding of a current transformer can be connected in series in a loop where a current flow, and the current output by the power input circuit is determined by detecting a current output by a secondary winding of the current transformer.

In high-frequency power conversion technologies, with increase of the frequency of power conversion, the required power density is increasing. Further, in high-frequency power conversion technologies, the current output by the power input circuit is strong. To control temperature rise of components and ensure reliability, a larger wire diameter is needed for winding into a current transformer, which increases the size of the current transformer. This, in one aspect, leads to rise of costs, and in another aspect, occupies a larger area of a printed circuit board (Printed Circuit Board, PCB), which restricts increase of the power density. Patent Document US 2006/132062 A1 discloses a high-frequency switch mode power supply, comprising a power input circuit, a power output circuit, a power transformer for coupling the power input circuit and the power output circuit and for transmitting power from the power input circuit to the power output circuit, and a current detection circuit, serially connected in the circuit formed by the power input circuit and the power transformer, for detecting the current in the circuit. Its current detection circuit comprises a current transformer circuit comprising a primary winding and a secondary winding, a detection unit with four diodes and a resistor, connected to the secondary winding, for detecting the current outputted by the secondary winding and in turn determining the current in the circuit.

Patent Document CN 101807857 discloses a high-frequency switch mode power supply, comprising a power input circuit, a power output circuit, a power transformer for coupling the power input circuit and the power output circuit and for transmitting power from the power input circuit to the power output circuit, and a current detection circuit on a secondary side of the power supply, with a current transformer, which comprises a primary winding and a secondary winding, wherein the primary winding and a capacitor are connected in series to serve as a first impedance branch. This first impedance branch and a second capacitor as a second impedance branch are connected in parallel and then connected in series in the secondary loop.

### SUMMARY

The embodiments of the present invention provide a high-frequency switch mode power supply and a method for detecting a high-frequency current to reduce the size of a current detecting circuit.

In a first aspect, there is provided a high-frequency switch mode power supply, comprising:
a power input circuit, configured to input power;
a power output circuit, configured to output power;
a power transformer, configured to couple the power input circuit and the power output circuit, and transmit power from the power input circuit to the power output circuit; and
a current detecting circuit, connected in series in a loop formed of the power input circuit and the power transformer, and configured to detect a current in the loop, wherein:
   the current detecting circuit comprises:
   a current transformer, which comprises a primary winding and at least one secondary winding, wherein the primary winding and an impedor are connected in series to serve as a first impedance branch connected in series in the loop;
   at least one second impedance branch and the first impedance branch are connected in parallel and then connected in series in the loop; and
   a detecting unit, connected to the secondary winding, and configured to detect a current output by the secondary winding so as to determine the current in the loop according to the current output by the secondary winding and relationships between the primary winding, the secondary winding, and the second impedance branch;
wherein the detecting unit comprises:
   a first diode, a second diode, a third diode, a fourth diode, and a resistor, wherein:
   a cathode of the first diode is electrically connected to an anode of the second diode;
   a cathode of the third diode is electrically connected to an anode of the fourth diode;
   an anode of the first diode is electrically connected to an anode of the third diode;
   a cathode of the second diode is electrically connected to a cathode of the fourth diode;
   one end of the secondary winding is electrically connected to a joint between the cathode of the first diode and the anode of the second diode, and the other end of the secondary winding is electrically connected to a joint between the cathode of the third diode and the anode of the fourth diode; and
   one end of the resistor is electrically connected to a joint between the anode of the first diode and the anode of the third diode, the other end of the resistor is electrically connected to a joint between the cathode of the second diode and the cathode of the fourth diode to output a detecting voltage so as to obtain the current at the secondary winding according to the detecting voltage and a resistance value of the resistor.

In a second aspect, there is provided a method for detecting a high-frequency current, comprising:
after connecting a first impedance branch formed of a primary winding of a current transformer and an impedor and at least one second impedance branch in parallel, shunting a current in a loop formed of a power input circuit and a power transformer; and
connecting, by a detecting unit, to a secondary winding of the current transformer and detecting a current output by the secondary winding so as to determine the current in the loop according to the current output by the secondary winding and relationships between the primary winding, the secondary winding, and the second impedance branch;
wherein the detecting unit comprises:
   a first diode, a second diode, a third diode, a fourth diode, and a resistor, wherein:
   a cathode of the first diode is electrically connected to an anode of the second diode;
   a cathode of the third diode is electrically connected to an anode of the fourth diode;
   an anode of the first diode is electrically connected to an anode of the third diode;
   a cathode of the second diode is electrically connected to a cathode of the fourth diode;
   wherein connecting, by the detecting unit, to a second winding comprises:
      electrically connecting one end of the secondary winding to a joint between the cathode of the first diode and the anode of the second diode;
      electrically connecting the other end of the secondary winding to a joint between the cathode of the third diode and the anode of the fourth diode;
      electrically connecting one end of the resistor to a joint between the anode of the first diode and the anode of the third diode; and
      electrically connecting the other end of the resistor to a joint between the cathode of the second diode and the cathode of the fourth diode to output a detecting voltage;
   wherein detecting a current output comprises obtaining the current at the secondary winding according to the detecting voltage and a resistance value of the resistor.

### BRIEF DESCRIPTION OF DRAWINGS

To illustrate the technical solutions in the embodiments of the present invention more clearly, the following briefly introduces the accompanying drawings required for describing the embodiments. Apparently, the accompanying drawings in the following description show some embodiments of the present invention, and persons of ordinary skill in the art may still derive other drawings from these accompanying drawings without creative efforts.
FIG. 1 is a schematic structural diagram of a high-frequency switch mode power supply according to an embodiment of the present invention;
FIG. 2 is a schematic structural diagram of a high-frequency switch mode power supply according to an embodiment of the present invention;
FIG. 3 is a schematic structural diagram of a high-frequency switch mode power supply according to an embodiment of the present invention;
FIG. 4 is a schematic structural diagram of a high-frequency switch mode power supply according to an embodiment of the present invention; and
FIG. 5 is a schematic structural diagram of a method for detecting a high-frequency current according to an embodiment of the present invention.

### DESCRIPTION OF EMBODIMENTS

To make the objectives, technical solutions, and advantages of the embodiments of the present invention more comprehensible, the following clearly and completely describes the technical solutions in the embodiments of the present invention with reference to the accompanying drawings in the embodiments of the present invention. Apparently, the described embodiments are merely a part rather than all of the embodiments of the present invention. All other embodiments obtained by persons of ordinary skill in the art based on the embodiments of the present invention without creative efforts shall fall within the protection scope of the present invention.

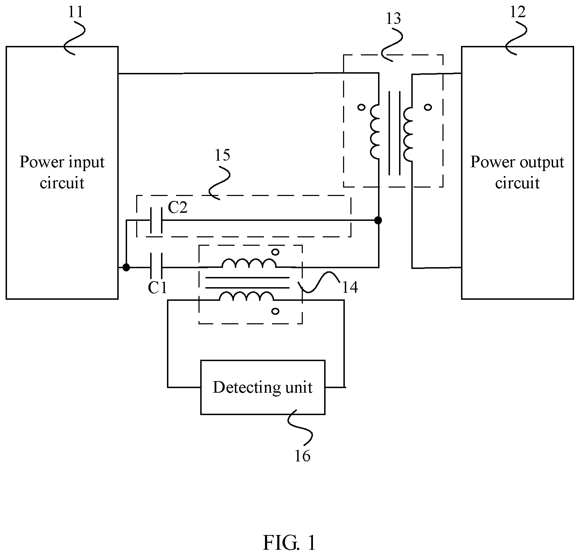

FIG. 1 is a schematic structural diagram of a high-frequency switch mode power supply system according to an embodiment of the present invention. The system includes a power input circuit 11, a power output circuit 12, a power transformer 13, and a current detecting circuit, where the current detecting circuit includes a current transformer 14, at least one second impedance branch 15 and a detecting unit 16;
The power input circuit 11 is configured to input power; the power output circuit 12 is configured to output power; the power transformer 13 is configured to couple the power input circuit and the power output circuit, and transmit power from the power input circuit to the power output circuit; and the current detecting circuit is connected in series in a loop formed of the power input circuit and the power transformer, and configured to detect a current in the loop.

Different from the prior art, the current detecting circuit includes the following units:
a current transformer 14, which includes a primary winding and at least one secondary winding, where the primary winding and an impedor (denoted by C1 in FIG. 1) are connected in series to serve as a first impedance branch connected in series in the loop;
at least one second impedance branch 15 (an impedor in the second impedance branch is denoted by C2 in FIG. 1) and the first impedance branch are connected in parallel and then connected in series in the loop; and
a detecting unit 16, connected to the at least one secondary winding, and configured to detect a current output by the secondary winding so as to determine a current in the loop according to the current output by the secondary winding and relationships between the primary winding, the secondary winding, and the second impedance branch 15. In the prior art, the primary winding of the current transformer is connected in series in the loop, that is, the current that flows through the primary winding is the current output by the power input circuit, and the current is very strong. Due to the very strong current, to avoid temperature rise and improve reliability, it is necessary to increase the wire diameter of a wire used for winding into the current transformer, which leads to an increase of size.

To solve the problem of increased size, a feasible solution is to reduce the value of the current that flows through the current detecting circuit.

In this embodiment, shunting is applied to reduce the value of the current that flows through the current detecting circuit.

In this embodiment, because the first impedance branch and the second impedance branch are connected in parallel and then connected in series in the loop, the current that flows through the first impedance branch will be weaker than the current in the loop, and the purpose of reducing the detect current is fulfilled.

Optionally, the detecting unit may include a rectifier circuit.

For bridge rectification or half-wave rectification, one secondary winding is employed; for full-wave rectification, two secondary windings are employed.

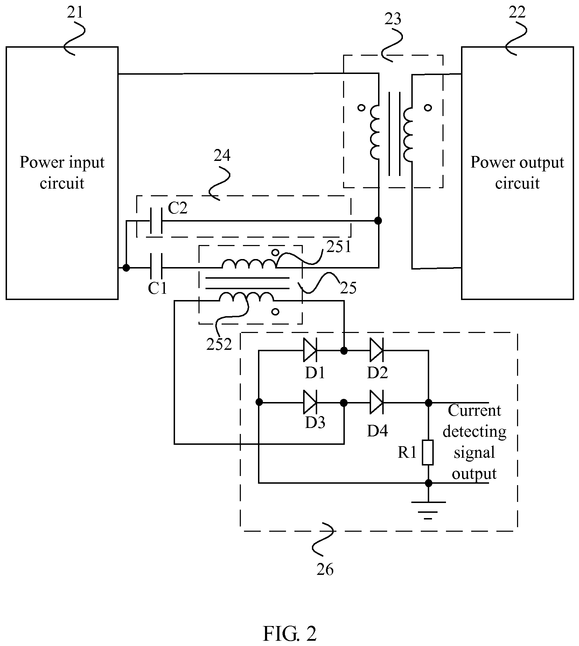

As shown in FIG. 2, it is assumed exemplarily that the current transformer includes one primary winding and one secondary winding, one second impedance branch and the first impedance branch formed by connecting the primary winding and the impedor in series are connected in parallel, and the detecting unit is specifically a rectifier circuit. The system includes a power input circuit 21, a power output circuit 22, a power transformer 23, a second impedance branch 24, a current transformer 25, and a rectifier circuit 26, where the current transformer 25 includes a primary winding 251 and a secondary winding 252.

For functions of the power input circuit 21, the power output circuit 22, and the power transformer 23, refer to the preceding embodiment.

The second impedance branch 24 and the first impedance branch are in a parallel connection relationship, the first impedance branch is formed by connecting the primary winding 251 of the current transformer 25 and the impedor C1 in series, and the second impedance branch and the first impedance branch are connected in parallel and then connected in series in a loop formed of the power input circuit 21 and the power transformer 23.

In this embodiment, the value of the impedance in the first impedance branch is far greater than a sum of an impedance value of the primary winding and a value of impedance refracted by the secondary winding onto the primary winding, where "far greater than" means "above 5 times".

In this embodiment, an impedor is exemplarily a capacitor. As shown in FIG. 2, the capacitor connected in series to the primary winding 251 is denoted by C1, and the capacitor in the second impedance branch is denoted by C2.

In this embodiment, the rectifier circuit 26 is formed of four diodes and one resistor, denoted by a first diode (D1), a second diode (D2), a third diode (D3), a fourth diode (D4), and a resistor (R1), respectively.

The connection relationships between the diodes and the resistor are as follows:
a cathode of the first diode is electrically connected to an anode of the second diode;
a cathode of the third diode is electrically connected to an anode of the fourth diode;
an anode of the first diode is electrically connected to an anode of the third diode;
a cathode of the second diode is electrically connected to a cathode of the fourth diode;
one end of the secondary winding is electrically connected to a joint between the cathode of the first diode and the anode of the second diode, and the other end of the secondary winding is electrically connected to a joint between the cathode of the third diode and the anode of the fourth diode; and
one end of the resistor is electrically connected to a joint between the anode of the first diode and the anode of the third diode, and the other end of the resistor is electrically connected to a joint between the cathode of the second diode and the cathode of the fourth diode.

The current that flows through the secondary winding 252 may be determined by detecting the voltage at R1; and then the current output by the power input circuit 21 may be obtained according to a relationship of the number of turns between the primary winding 251 and the secondary winding 252 and an impedance relationship between the parallel-connected branches.

It is assumed that the voltage detected at R1 is denoted by V, the resistance value of R1 is denoted by R, the impedance of the C1 branch is n times that of the C2 branch, the number of turns of the secondary winding 252 of the current transformer 25 is m times that of the primary winding 251. The value of impedance of the C1 branch is greater than the sum of the impedance value of the primary winding 251 and the value of impedance refracted by the secondary winding 252 onto the primary winding 251. Specifically, "greater than" here refers to "far greater than", and "far greater than" means that, during determining the impedance relationship between the C1 branch and the C2 branch, the sum of the impedance value of the primary winding 251 and the value of impedance refracted by the secondary winding 252 onto the primary winding 251 is ignorable.

Under such assumptions, the current output by the power input circuit is I = (1 + n) × (V/R) × m.

For example, assuming that the ratio of the number of turns of the primary winding to the number of turns of the secondary winding is 1:50, the resistance of R1 is 100 ohms, C1:C2 = 1:2, and the voltage detected at R1 is 2 volts, and therefore I = 3 amperes.

In this embodiment, a branch connected in parallel to the primary winding is set in a loop to reduce the value of a current that flows through the primary winding; and a small-sized current transformer can be used to detect a strong current output by the power input circuit, thereby reducing costs and avoiding limitation on the power density.

Optionally, the impedor in each impedance branch may be a capacitor, an inductor, or a resistor. Optionally, the power input circuit may be a high-frequency switching power circuit or a high-frequency alternating current power circuit.

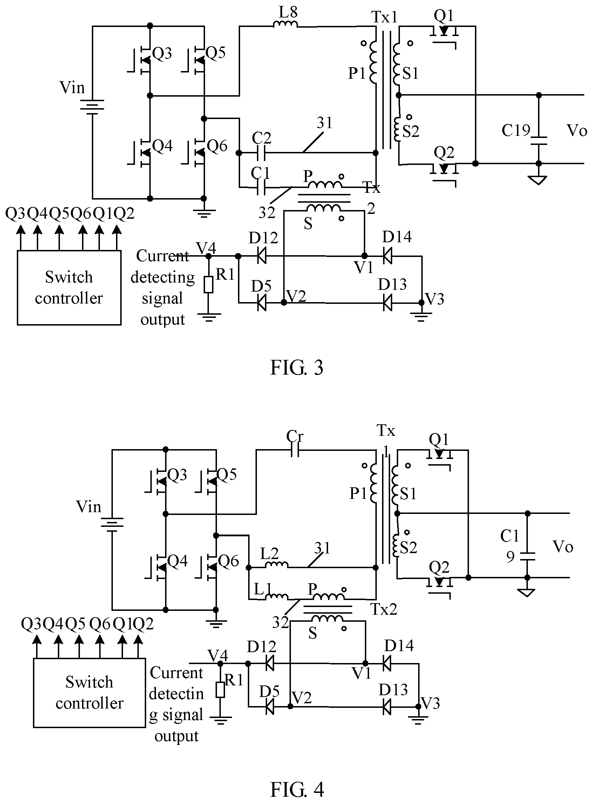

In FIG. 3 and FIG. 4, it is assumed that the impedor is a capacitor and an inductor, respectively, and the power input circuit and the power output circuit are high-frequency switching power circuits. Specifically, the power input circuit, that is, a primary side, makes up a full-bridge converter, where the primary side is formed of four metal-oxide-semiconductor field effect transistors (Metal-Oxide-Semiconductor Field-Effect Transistor, MOSFET), Q3, Q4, Q5, and Q6. Q3 and Q4 make up one bridge arm, and Q5 and Q6 make up another bridge arm.

The power output circuit, that is, a secondary side, is formed of 2 MOSFETs, Q1 and Q2.

A switch controller controls periodical conduction and cut-off of Q3, Q4, Q5, Q6, Q1, and Q2.

The midpoints A and B of two bridge arms are periodically connected to the anode of the input power supply and a ground in turn, and thereby a high-frequency alternating current voltage is formed between A and B.

The power transformer TX1 induces the high-frequency alternating current voltage to the secondary side, and then after rectification by Q1 and Q2 and filtering by C19, a direct current output voltage Vo is formed.

In order to know the operating state of the converter, the current that flows through the power transformer TX1 needs to be detected. The power that flows through the power transformer TX1 is divided into two branches, and, as shown in FIG. 3 for example, one branch is made up of C2 and a wire 31; and the other is made up of a capacitor C1, a wire 32, and a current transformer TX2. In addition, the sum of the impedance of the primary side (or the primary winding) of the current transformer TX2 and the impedance refracted by the secondary side (or the secondary winding) onto the primary side is far less than the impedance of C1, so that the connection of the current transformer does not bring significant impact on the current distribution relationship. The current transformer can detect the current in the C1 branch. Because the impedance of C1 and the impedance of C2 are in a fixed proportion, the currents in the two branches are also in a fixed proportion. According to the calculation method in the preceding embodiment, the current output by the power input circuit, or the current that flows through the power transformer TX1, is obtained.

Similar to the current detecting process in the preceding embodiment, the detecting of the current in the C1 branch is performed through a rectifier circuit. As shown in FIG. 3 or FIG. 4, the rectifier circuit includes four diodes and a resistor, denoted by D12, D14, D5, D13, and R1, respectively. The cathode of D14 is electrically connected to the anode of D12; the cathode of D13 is electrically connected to the anode of D5; the anode of D14 is electrically connected to the anode of D13; the cathode of D12 is electrically connected to the cathode of D5; one end of the secondary winding is electrically connected to a joint between the cathode of D14 and the anode of D12 (the joint is denoted by VI), and the other end of the secondary winding is electrically connected to a joint between the cathode of D13 and the anode of D5 (the joint is denoted by V2); one of R1 is electrically connected to a joint between the anode of D14 and the anode of D13 (the joint is denoted by V3, and grounded), and the other end of R1 is electrically connected to a joint between the cathode of D12 and the cathode of D5 (the joint is denoted by V4). The current output by the secondary winding of the current transformer can control the conduction or cut-off of D12, D14, D5, and D13, and then the current output by the secondary winding circulates between the conducted diodes and R1. For example, when the current that flows through the secondary winding flows from right to left (that is, VI is of a high level, and V2 is of a low level) as shown in FIG. 3 or FIG. 4, D12 and D13 are conducted, and D14 and D5 are cut off. Afterwards, the current output from the secondary winding circulates in a loop obtained by connecting D12, R1, D13, and the secondary winding in series. During the detection, the voltage at R1 may be detected, and the resistance of the voltage at R1 can be used to obtain the current at R1, that is, the current that circulates in the secondary winding. Afterwards, according to the ratio of the number of turns of the secondary winding to that of the primary winding, the current at the primary winding can be obtained; and according to the impedance relationship between the impedance branches, the current output by the power input circuit can be obtained.

FIG. 3 differs from FIG. 4 in that a capacitor exists in the impedance branch in FIG. 3, but an inductor exists in the impedance branch in FIG. 4, both serving the purpose of shunting. As shown in FIG. 3, the impedors in both impedance branches are capacitors, which are C2 and C1, respectively; as shown in FIG. 4, the impedors in both impedance branches are inductors, which are L2 and L1 respectively. In addition, the impedor in the loop formed of the power input circuit and TX1 is opposite to the impedor in the impedance branch, so that TX1 can couple the input power to the output loop smoothly. The impedor in the impedance branch in FIG. 3 is a capacitor, and the impedor in the loop is an inductor L8; while the impedor in the impedance branch in FIG. 4 is an inductor, and the impedor in the loop is a capacitor Cr.

In this embodiment, the current output by a power input module is shunted by the current detecting circuit. The shunted current is weaker than the current output by the power input circuit, which avoids the problem that a large-sized current detecting circuit of is required due to a strong current, and implements current detecting with a current detecting circuit of a smaller size, therefore reducing costs and increasing power density of a power converter.

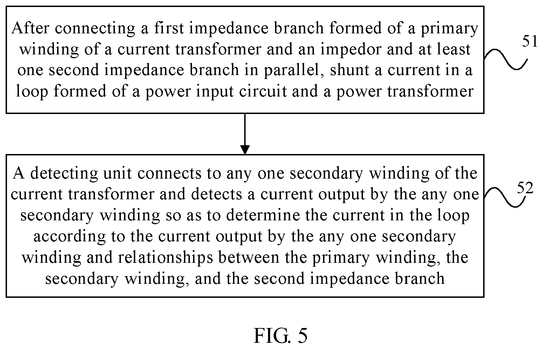

FIG. 5 is a schematic flowchart of a method for detecting a high-frequency current according to an embodiment of the present invention. The method includes:
Step 51: After connecting a first impedance branch formed of a primary winding of a current transformer and an impedor and at least one second impedance branch in parallel, shunt a current in a loop formed of a power input circuit and a power transformer.
Step 52: A detecting unit connects to a secondary winding of the current transformer and detects a current output by the secondary winding so as to determine the current in the loop according to the current output by the secondary winding and relationships between the primary winding, the secondary winding, and the second impedance branch.

The method in this embodiment is a method applied when the foregoing high-frequency switch mode power supply is used to detect a current. For detailed composition of the high-frequency switch mode power supply used in the method in this embodiment, reference may be made to the preceding embodiment.

Optionally, the detecting, by the detecting unit, a current output by the secondary winding, includes:
converting, by a resistor in a rectifier circuit, the current to a voltage, so that the current output by the secondary winding is obtained according to the voltage and a resistance value of the resistor, where a current that flows through the resistor is a current obtained after the secondary winding of the current transformer converts a current at the primary winding.

Optionally,
when the first impedance branch includes an inductor, the second impedance branch is formed of a wire and an inductor; or
when the first impedance branch includes a capacitor, the second impedance branch is formed of a wire and a capacitor.

Optionally, an impedance value of the impedor in the first impedance branch is greater than 5 times a sum of an impedance value of the primary winding and a value of impedance refracted by the secondary winding onto the primary winding.

Optionally, the power input circuit is a high-frequency switching power circuit or a high-frequency alternating current power circuit.

In this embodiment, the current output by a power input module is shunted by the branch that includes the primary winding. The shunted current is weaker than the current output by the power input circuit, which avoids the problem that a large-sized current detecting circuit is required due to a strong current and implements current detecting with a current detecting circuit of a smaller size, therefore reducing costs and increasing power density of a power converter.

Finally, it should be noted that the foregoing embodiments are merely intended for describing the technical solutions of the present invention other than limiting the present invention. Although the present invention is described in detail with reference to the foregoing embodiments, persons of ordinary skill in the art should understand that they may still make modifications to the technical solutions described in the foregoing embodiments, or make equivalent replacements to some or all the technical features thereof, without departing from the scope of the technical solutions of the embodiments of the present invention.

## Claims

1. A high-frequency switch mode power supply, comprising:
a power input circuit (11), configured to input power;
a power output circuit (12), configured to output power;
a power transformer (13), configured to couple the power input circuit and the power output circuit, and transmit power from the power input circuit to the power output circuit; and
a current detecting circuit (16), connected in series in a loop formed of the power input circuit and the power transformer, and configured to detect a current in the loop, wherein:
the current detecting circuit comprises:
a current transformer (14), which comprises a primary winding and at least one secondary winding, wherein the primary winding and an impedor are connected in series to serve as a first impedance branch connected in series in the loop;
at least one second impedance branch (15) and the first impedance branch are connected in parallel and then connected in series in the loop; and
a detecting unit, connected to the secondary winding, and configured to detect a current output by the secondary winding so as to determine the current in the loop according to the current output by the secondary winding and relationships between the primary winding, the secondary winding, and the second impedance branch;
wherein the detecting unit comprises:
a first diode, a second diode, a third diode, a fourth diode, and a resistor, wherein:
a cathode of the first diode is electrically connected to an anode of the second diode;
a cathode of the third diode is electrically connected to an anode of the fourth diode;
an anode of the first diode is electrically connected to an anode of the third diode;
a cathode of the second diode is electrically connected to a cathode of the fourth diode;
one end of the secondary winding is electrically connected to a joint between the cathode of the first diode and the anode of the second diode, and the other end of the secondary winding is electrically connected to a joint between the cathode of the third diode and the anode of the fourth diode; and
one end of the resistor is electrically connected to a joint between the anode of the first diode and the anode of the third diode, the other end of the resistor is electrically connected to a joint between the cathode of the second diode and the cathode of the fourth diode to output a detecting voltage so as to obtain the current at the secondary winding according to the detecting voltage and a resistance value of the resistor.

2. The power supply according to claim 1, wherein: an impedance value of the impedor in the first impedance branch is greater than 5 times a sum of an impedance value of the primary winding and a value of impedance refracted by the secondary winding onto the primary winding.

3. The power supply according to claim 2, wherein:
the impedor is a capacitor, and each of the impedance branches is formed of a wire and a capacitor; or
the impedor is an inductor, and each of the impedance branches is formed of a wire and an inductor.

4. The power supply according to any one of claims 1 to 3, wherein: the power input circuit is a high-frequency switching power circuit or a high-frequency alternating current power circuit.

5. A method for detecting a high-frequency current, comprising:
after connecting a first impedance branch formed of a primary winding of a current transformer and an impedor and at least one second impedance branch in parallel, shunting (51) a current in a loop formed of a power input circuit and a power transformer; and
connecting (52), by a detecting unit, to a secondary winding of the current transformer and detecting a current output by the secondary winding so as to determine the current in the loop according to the current output by the secondary winding and relationships between the primary winding, the secondary winding, and the second impedance branch;
wherein the detecting unit comprises:
a first diode, a second diode, a third diode, a fourth diode, and a resistor, wherein:
a cathode of the first diode is electrically connected to an anode of the second diode;
a cathode of the third diode is electrically connected to an anode of the fourth diode;
an anode of the first diode is electrically connected to an anode of the third diode;
a cathode of the second diode is electrically connected to a cathode of the fourth diode;
wherein connecting, by the detecting unit, to a second winding comprises:
electrically connecting one end of the secondary winding to a joint between the cathode of the first diode and the anode of the second diode;
electrically connecting the other end of the secondary winding to a joint between the cathode of the third diode and the anode of the fourth diode;
electrically connecting one end of the resistor to a joint between the anode of the first diode and the anode of the third diode; and
electrically connecting the other end of the resistor to a joint between the cathode of the second diode and the cathode of the fourth diode to output a detecting voltage;
wherein detecting a current output comprises obtaining the current at the secondary winding according to the detecting voltage and a resistance value of the resistor.

6. The method according to claim 5, wherein the detecting, by the detecting unit, a current output by the secondary winding, comprises:
converting, by a resistor in a rectifier circuit, the current to voltage, so that the current output by the secondary winding is obtained according to the voltage and a resistance value of the resistor, wherein a current that flows through the resistor is a current obtained after the secondary winding of the current transformer converts a current at the primary winding.

7. The method according to claim 5, wherein:
when the first impedance branch comprises an inductor, the second impedance branch is formed of a wire and an inductor; or
when the first impedance branch comprises a capacitor, the second impedance branch is formed of a wire and a capacitor.

8. The method according to claim 5, wherein: an impedance value of the impedor in the first impedance branch is greater than 5 times a sum of an impedance value of the primary winding and a value of impedance refracted by the secondary winding onto the primary winding.

9. The method according to any one of claims 5 to 8, wherein: the power input circuit is a high-frequency switching power circuit or a high-frequency alternating current power circuit.

## Patentansprüche

1. Hochfrequenz-Schaltmodusnetzteil, umfassend:
einen Leistungseingangsschaltkreis (11), der zum Eingeben von Leistung konfiguriert ist;
einen Leistungsausgangsschaltkreis (12), der zum Ausgeben von Leistung konfiguriert ist;
einen Leistungstransformator (13), der konfiguriert ist, um den Leistungseingangsschaltkreis und den Leistungsausgangsschaltkreis zu koppeln und
Leistung von dem Leistungseingangsschaltkreis auf den Leistungsausgangsschaltkreis zu übertragen; und
einen Stromdetektierungsschaltkreis (16), der in Reihe in einer Schleife verbunden ist, die aus dem Leistungseingangsschaltkreis und dem Netztransformator gebildet ist, und konfiguriert ist, um einen Strom in der Schleife zu detektieren, wobei:
der Stromdetektierungsschaltkreis umfasst:
einen Stromtransformator (14), der eine Primärwicklung und mindestens eine Sekundärwicklung umfasst, wobei die Primärwicklung und eine Impedanz in Reihe verbunden sind, um als erster Impedanzzweig zu dienen, der in Reihe in der Schleife verbunden ist;
mindestens ein zweiter Impedanzzweig (15) und der erste Impedanzzweig parallel verbunden sind und dann in Reihe in der Schleife verbunden sind; und
eine Detektierungseinheit, die mit der Sekundärwicklung verbunden ist und konfiguriert ist, um eine Stromausgabe durch die Sekundärwicklung zu detektieren, um so den Strom in der Schleife gemäß der Stromausgabe durch die Sekundärwicklung und Beziehungen zwischen der Primärwicklung, der Sekundärwicklung und dem zweiten Impedanzzweig zu detektieren;
wobei die Detektierungseinheit umfasst:
eine erste Diode, eine zweite Diode, eine dritte Diode, eine vierte Diode und einen Widerstand, wobei:
eine Kathode der ersten Diode elektrisch mit einer Anode der zweiten Diode verbunden ist;
eine Kathode der dritten Diode elektrisch mit einer Anode der vierten Diode verbunden ist;
eine Anode der ersten Diode elektrisch mit einer Anode der dritten Diode verbunden ist;
eine Kathode der zweiten Diode elektrisch mit einer Kathode der vierten Diode verbunden ist;
ein Ende der Sekundärwicklung elektrisch mit einer Verbindungsstelle zwischen der Kathode der ersten Diode und der Anode der zweiten Diode verbunden ist, und das andere Ende der Sekundärwicklung elektrisch mit einer Verbindungsstelle zwischen der Kathode der dritten Diode und der Anode der vierten Diode verbunden ist; und
ein Ende des Widerstands elektrisch mit einer Verbindungsstelle zwischen der Anode der ersten Diode und der Anode der dritten Diode verbunden ist, wobei das andere Ende des Widerstands elektrisch mit einer Verbindungsstelle zwischen der Kathode der zweiten Diode und der Kathode der vierten Diode verbunden ist, um eine Detektierungsspannung auszugeben, um so den Strom an der Sekundärwindung gemäß der Detektierungsspannung und einem ohmschen Widerstandswert des Widerstands zu erhalten.

2. Netzteil nach Anspruch 1, wobei ein Impedanzwert der Impedanz in dem ersten Impedanzzweig größer als das 5-fache einer Summe eines Impedanzwerts der Primärwicklung und eines Impedanzwerts ist, der durch die Sekundärwicklung auf die Primärwicklung gelenkt wird.

3. Netzteil nach Anspruch 2, wobei
die Impedanz ein Kondensator ist, und jeder der Impedanzzweige aus einem Draht und einem Kondensator gebildet ist; oder
die Impedanz eine Spule ist, und jeder der Impedanzzweige aus einem Draht und einer Spule gebildet ist.

4. Netzteil nach einem der Ansprüche 1 bis 3, wobei ein Leistungseingangsschaltkreis ein Hochfrequenz-Schaltleistungsschaltkreis oder ein Hochfrequenz-Wechselspannungsleistungsschaltkreis ist.

5. Verfahren zum Detektieren eines Hochfrequenzstroms, umfassend:
nach dem Verbinden eines ersten Impedanzzweigs, der aus einer Primärwicklung eines Stromtransformators und einer Impedanz gebildet ist, und mindestens eines zweiten Impedanzzweigs in Parallelschaltung, Shunten (51) eines Stroms in einer Schleife, die aus einem Leistungseingangsschaltkreis und einem Netztransformator gebildet ist; und
Verbinden (52) mit einer Sekundärwicklung des Stromtransformators durch eine Detektierungseinheit, und Detektieren einer Stromausgabe durch die Sekundärwicklung, um so den Strom in der Schleife gemäß der Stromausgabe durch die Sekundärwicklung und Beziehungen zwischen der Primärwicklung, der Sekundärwicklung und dem zweiten Impedanzzweig zu detektieren;
wobei die Detektierungseinheit umfasst:
eine erste Diode, eine zweite Diode, eine dritte Diode, eine vierte Diode und einen Widerstand, wobei:
eine Kathode der ersten Diode elektrisch mit einer Anode der zweiten Diode verbunden ist;
eine Kathode der dritten Diode elektrisch mit einer Anode der vierten Diode verbunden ist;
eine Anode der ersten Diode elektrisch mit einer Anode der dritten Diode verbunden ist;
eine Kathode der zweiten Diode elektrisch mit einer Kathode der vierten Diode verbunden ist;
wobei Verbinden mit einer Sekundärwicklung durch die Detektierungseinheit umfasst:
elektrisches Verbinden eines Endes der Sekundärwicklung mit einer Verbindungsstelle zwischen der Kathode der ersten Diode und der Anode der zweiten Diode;
elektrisches Verbinden des anderen Endes der Sekundärwicklung mit einer Verbindungsstelle zwischen der Kathode der dritten Diode und der Anode der vierten Diode;
elektrisches Verbinden eines Endes des Widerstands mit einer Verbindungsstelle zwischen der Anode der ersten Diode und der Anode der dritten Diode; und
elektrisches Verbinden des anderen Endes des Widerstands mit einer Verbindungsstelle zwischen der Kathode der zweiten Diode und der Kathode der vierten Diode, um eine Detektierungsspannung auszugeben;
wobei Detektieren einer Stromausgabe Erhalten des Stroms an der Sekundärwicklung gemäß der Detektierungsspannung und einem ohmschen Widerstandswert des Widerstands umfasst.

6. Verfahren nach Anspruch 5, wobei das Detektieren einer Stromausgabe durch die Sekundärwicklung durch die Detektierungseinheit umfasst:
Wandeln des Stroms zu Spannung durch einen Widerstand in einer Gleichrichterschaltung, so dass die Stromausgabe durch die Sekundärwicklung gemäß der Spannung und einem ohmschen Widerstandswert des Widerstands erhalten wird, wobei ein Strom, der durch den Widerstand fließt, ein Strom ist, der erhalten wurde, nachdem die Sekundärwicklung des Stromtransformators einen Strom an der Primärwicklung wandelt.

7. Verfahren nach Anspruch 5, wobei:
wenn der erste Impedanzzweig einen Induktor umfasst, der zweite Impedanzzweig aus einem Draht und einem Induktor gebildet ist; oder
wenn der erste Impedanzzweig einen Kondensator umfasst, der zweite Impedanzzweig aus einem Draht und einem Kondensator gebildet ist.

8. Verfahren nach Anspruch 5, wobei: ein Impedanzwert der Impedanz in dem ersten Impedanzzweig größer als das 5-fache einer Summe eines Impedanzwerts der Primärwicklung und eines Impedanzwerts ist, der durch die Sekundärwicklung auf die Primärwicklung gelenkt wird.

9. Verfahren nach einem der Ansprüche 5 bis 8, wobei: ein Leistungseingangsschaltkreis ein Hochfrequenz-Schaltleistungsschaltkreis oder ein Hochfrequenz-Wechselspannungsleistungsschaltkreis ist.

## Revendications

1. Alimentation à découpage à haute fréquence, comprenant :
un circuit d'entrée de puissance (11), configuré pour apporter de l'énergie ;
un circuit de sortie de puissance (12), configuré pour délivrer de l'énergie ;
un transformateur de puissance (13), configuré pour coupler le circuit d'entrée de puissance et le circuit de sortie de puissance, et transmettre de l'énergie du circuit d'entrée de puissance au circuit de sortie de puissance ; et
un circuit de détection de courant (16), branché en série dans une boucle constituée du circuit d'entrée de puissance et du transformateur de puissance, et configuré pour détecter un courant dans la boucle, dans laquelle :
le circuit de détection de courant comprend :
un transformateur de courant (14), qui comprend un enroulement primaire et au moins un enroulement secondaire, l'enroulement primaire et un élément à impédance étant branchés en série pour servir de première branche d'impédance branchée en série dans la boucle ;
au moins une deuxième branche d'impédance (15) et la première branche d'impédance sont branchées en parallèle et branchées ensuite en série dans la boucle ; et
une unité de détection, branchée à l'enroulement secondaire, et configurée pour détecter un courant délivré par l'enroulement secondaire de manière à déterminer le courant dans la boucle en fonction du courant délivré par l'enroulement secondaire et de relations entre l'enroulement primaire, l'enroulement secondaire, et la deuxième branche d'impédance ;
dans laquelle l'unité de détection comprend :
une première diode, une deuxième diode, une troisième diode, une quatrième diode, et une résistance, dans laquelle :
une cathode de la première diode est branchée électriquement à une anode de la deuxième diode ;
une cathode de la troisième diode est branchée électriquement à une anode de la quatrième diode ;
une anode de la première diode est branchée électriquement à une anode de la troisième diode ;
une cathode de la deuxième diode est branchée électriquement à une cathode de la quatrième diode ;
une extrémité de l'enroulement secondaire est branchée électriquement à un raccordement entre la cathode de la première diode et l'anode de la deuxième diode, et l'autre extrémité de l'enroulement secondaire est branchée électriquement à un raccordement entre la cathode de la troisième diode et l'anode de la quatrième diode ; et
une extrémité de la résistance est branchée électriquement à un raccordement entre l'anode de la première diode et l'anode de la troisième diode, l'autre extrémité de la résistance est branchée électriquement à un raccordement entre la cathode de la deuxième diode et la cathode de la quatrième diode pour délivrer une tension de détection de manière à obtenir le courant au niveau de l'enroulement secondaire en fonction de la tension de détection et d'une valeur de résistance de la résistance.

2. Alimentation selon la revendication 1, dans laquelle : une valeur d'impédance de l'élément à impédance dans la première branche d'impédance est supérieure à 5 fois une somme d'une valeur d'impédance de l'enroulement primaire et d'une valeur d'impédance réfractée par l'enroulement secondaire sur l'enroulement primaire.

3. Alimentation selon la revendication 2, dans laquelle :
l'élément à impédance est un condensateur, et chacune des branches d'impédance est constituée d'un fil et d'un condensateur ; ou
l'élément à impédance est une bobine d'induction, et chacune des branches d'impédance est constituée d'un fil et d'une bobine d'induction.

4. Alimentation selon l'une quelconque des revendications 1 à 3, dans laquelle : le circuit d'entrée de puissance est un circuit d'alimentation à commutation à haute fréquence ou un circuit d'alimentation en courant alternatif à haute fréquence.

5. Procédé de détection d'un courant à haute fréquence, comprenant :
après le branchement d'une première branche d'impédance constituée d'un enroulement primaire d'un transformateur de courant et d'un élément à impédance et d'au moins une deuxième branche d'impédance en parallèle, la dérivation (51) d'un courant dans une boucle constituée d'un circuit d'entrée de puissance et d'un transformateur de puissance ; et
le branchement (52), par une unité de détection, à un enroulement secondaire du transformateur de courant et la détection d'un courant délivré par l'enroulement secondaire de manière à déterminer le courant dans la boucle en fonction du courant délivré par l'enroulement secondaire et de relations entre l'enroulement primaire, l'enroulement secondaire, et la deuxième branche d'impédance ;
dans lequel l'unité de détection comprend :
une première diode, une deuxième diode, une troisième diode, une quatrième diode, et une résistance, dans lequel :
une cathode de la première diode est branchée électriquement à une anode de la deuxième diode ;
une cathode de la troisième diode est branchée électriquement à une anode de la quatrième diode ;
une anode de la première diode est branchée électriquement à une anode de la troisième diode ;
une cathode de la deuxième diode est branchée électriquement à une cathode de la quatrième diode ;
dans lequel le branchement, par l'unité de détection, à un deuxième enroulement comprend :
le branchement électrique d'une extrémité de l'enroulement secondaire à un raccordement entre la cathode de la première diode et l'anode de la deuxième diode ;
le branchement électrique de l'autre extrémité de l'enroulement secondaire à un raccordement entre la cathode de la troisième diode et l'anode de la quatrième diode ;
le branchement électrique d'une extrémité de la résistance à un raccordement entre l'anode de la première diode et l'anode de la troisième diode ; et
le branchement électrique de l'autre extrémité de la résistance à un raccordement entre la cathode de la deuxième diode et la cathode de la quatrième diode pour délivrer une tension de détection ;
dans lequel la détection d'une sortie de courant comprend l'obtention du courant au niveau de l'enroulement secondaire en fonction de la tension de détection et d'une valeur de résistance de la résistance.

6. Procédé selon la revendication 5, dans lequel la détection, par l'unité de détection, d'un courant délivré par l'enroulement secondaire comprend :
la conversion, par une résistance dans un circuit redresseur, du courant en tension, de telle sorte que le courant délivré par l'enroulement secondaire est obtenu en fonction de la tension et d'une valeur de résistance de la résistance, dans lequel un courant qui circule à travers la résistance est un courant obtenu après que l'enroulement secondaire du transformateur de courant a converti un courant au niveau de l'enroulement primaire.

7. Procédé selon la revendication 5, dans lequel :
quand la première branche d'impédance comprend une bobine d'induction, la deuxième branche d'impédance est constituée d'un fil et d'une bobine d'induction ; ou
quand la première branche d'impédance comprend un condensateur, la deuxième branche d'impédance est constituée d'un fil et d'un condensateur.

8. Procédé selon la revendication 5, dans lequel : une valeur d'impédance de l'élément à impédance dans la première branche d'impédance est supérieure à 5 fois une somme d'une valeur d'impédance de l'enroulement primaire et d'une valeur d'impédance réfractée par l'enroulement secondaire sur l'enroulement primaire.

9. Procédé selon l'une quelconque des revendications 5 à 8, dans lequel : le circuit d'entrée de puissance est un circuit d'alimentation à commutation à haute fréquence ou un circuit d'alimentation en courant alternatif à haute fréquence.
